**Europäisches Patentamt**

**European Patent Office**

**Office européen des brevets**

(19)

(11) Publication number : **0 239 208 B1**

(12) **EUROPEAN PATENT SPECIFICATION**

(45) Date of publication of patent specification :
10.07.91 Bulletin 91/28

(51) Int. Cl.⁵ : **G11C 11/409**

(21) Application number : **87301110.0**

(22) Date of filing : **09.02.87**

(54) Dynamic RAM.

(30) Priority : **25.02.86 JP 41043/86**

(43) Date of publication of application :
**30.09.87 Bulletin 87/40**

(45) Publication of the grant of the patent :
**10.07.91 Bulletin 91/28**

(84) Designated Contracting States :
**DE FR GB**

(56) References cited :
DE-B- 2 647 394
IEEE JOURNAL OF SOLID-STATE CIRCUITS,
vol. SC-19, no. 4, August 1984, pages 451-454,
IEEE, New York, US; N.CHAU-CHUN LU et al.:
"Half-VDD Bit-line sensing scheme in CMOS
DRAM's"
IEEE ISSCC, 28. Febr. 85, New York, US, pp.
252-253, SAITO et al.: "A 1Mb CMOS DRAM
with Fast Page and Static Column Modes"

(73) Proprietor : **MITSUBISHI DENKI KABUSHIKI
KAISHA**
**2-3, Marunouchi 2-chome Chiyoda-ku
Tokyo 100 (JP)**

(72) Inventor : **Miyamoto, Hiroshi Mitsubishi Denki
K.K. LSI
Kenkyusho 1 Mizuhara 4-chome
Itami-shi Hyogo-ken (JP)**
Inventor : **Yamada, Michihiro Mitsubishi Denki
K.K. LSI
Kenkyusho 1 Mizuhara 4-chome
Itami-shi Hyogo-ken (JP)**

(74) Representative : **Beresford, Keith Denis Lewis
et al
BERESFORD & Co. 2-5 Warwick Court High
Holborn
London WC1R 5DJ (GB)**

Jouve, 18, rue Saint-Denis, 75001 PARIS

## Description

The present invention relates to a dynamic random access memory (dynamic RAM). In particular it concerns a memory having a folded bit-line structure and which typically can be formed by an MOS process.

A dynamic RAM having a folded bit-line structure is known and is described for example in United States Patent No 4,122,546 (Von Basse et al). In one arrangement, shown in figure 3 of this reference, the memory cells are connected to a pair of bit-lines and the latter arranged across a weighting network, specifically an MOS flip-flop, located at one end of the pair of bit-lines and on one side only of all the memory cells. This replaces an earlier type of structure in which the memory cells are connected to lines extending each side of the weighting network. Because of the line pairing and localised arrangement of memory cells, more consistent electrical properties and thus improved behaviour are said to be attainable. A similar arrangement is also described in the article entitled "A 1 Mb CMOS DRAM with Fast Page and Static Column Modes" by Saito, S. et al in IEEE International Solid State Circuits Conference, 28 Feb 1985, New York, USA, pages 252 and 253. In this arrangement a CMOS amplifier (having a sense amplifier portion and a restore circuit portion, respectively, formed of complementary conductivity type transistors) is used in place of the flip-flop weighting network.

A dynamic RAM generally employs a memory cell comprising a single transistor and a single capacitor. In this case, the smaller the ratio of capacitance of a bit-line to capacitance of a capacitor in a memory cell is, the larger amount of change in potential on a bit-line at the time of read-out is, and the larger input potential difference for a sense amplifier is, so that read-out operation is ensured. However, as the density of a memory is increased significantly and integration increased, the size of each memory cell is made smaller, and consequently the capacitance of each capacitor is reduced. On the other hand, since the number of memory cells connected to a single bit-line is also increased, each bit line becomes longer, and thus the capacitance of each bit-line tends to be increased. As a result, the ratio of the capacitance of each bit-line to the capacitance of each memory capacitor is increased, so that eventually read-out operation can become unreliable.

To solve this problem, each bit-line is divided up and the memory cells are divided into a corresponding plurality of blocks so that the ratio of the capacitance of a memory capacitor to the capacitance of each bit line is then reduced.

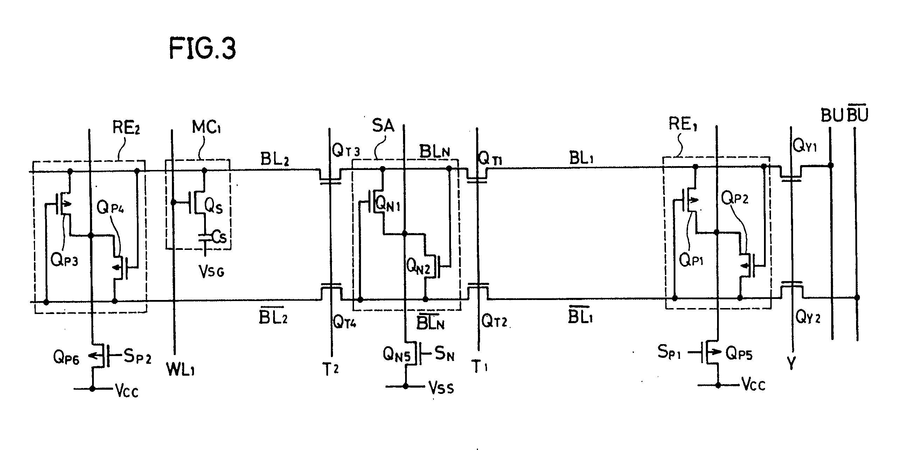

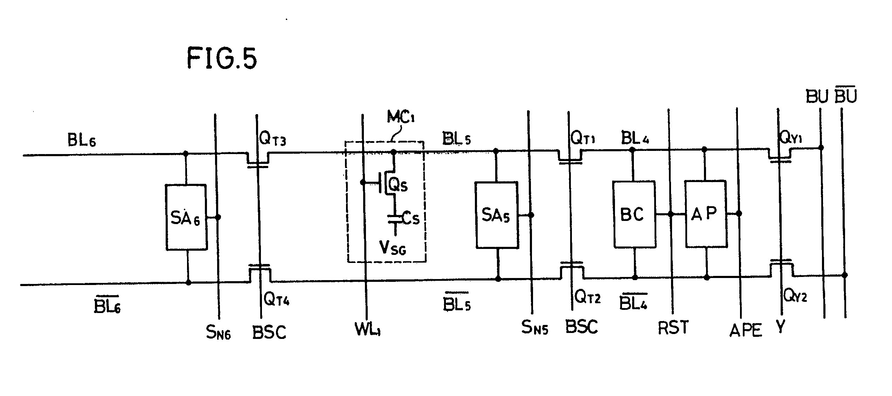

This is shown in the arrangement of figure 7 of, and is discussed in, the reference US 4, 122, 546 just acknowledged. In the more recent development of dynamic RAM the functions of pull-up and pull-down amplification have been performed respectively by spaced sense amplifiers and restore circuits of complementary transistor type. In each of the two examples shown in figures 3 and 5 either a sense amplifier or a restore circuit is provided adjacent to each memory cell block and the other is provided either as a shared resource, one between two (figure 3) or as a common resource, at one end of the paired bit-line (figure 5). As will be outlined below, each of these arrangements proves to be disadvantageous.

Fig. 3 is a diagram showing a part of a structure of a conventional dynamic RAM, which is disclosed in an article of Digest of Technical Papers, ISSCC 84, pp. 278-279. In Fig. 3, a so-called shared sense amplifier structure is shown wherein a pair of bit lines are divided into two parts BL1 and $\overline{BL1}$ and BL2 and $\overline{BL2}$ and a sense amplifier is shared with each pair of divided bit lines. In the above described document, a transistor in a memory cell comprises a P channel transistor, a sense amplifier comprises a P channel transistor, and a restore circuit comprises an N channel transistor. For simplicity, the conductivity type of these transistors is inverted in Fig. 3.

In Fig. 3, a pair of bit lines constituting a folded bit line are divided into divided bit lines BL1, BLN and BL2 and divided bit lines $\overline{BL1}$, $\overline{BLN}$ and $\overline{BL2}$, respectively. A sense amplifier SA is connected to the divided bit lines BLN and $\overline{BLN}$, a restore circuit RE1 is connected to the divided bit lines BL1 and $\overline{BL1}$, and a restore circuit RE2 is connected to the divided bit lines BL2 and $\overline{BL2}$. The sense amplifier SA comprises N channel transistors QN1 and QN2 as described above, and the restore circuit RE1 and RE2 comprise P channel transistors QP1 and QP2 and QP3 and QP4, respectively.

The transistors QN1 and QN2 have sources connected to a common sense amplifier driver transistor QN5. The transistor QN5 has a gate receiving a sense amplifier activating signal SN. The transistors QP1 and QP2 have sources connected to a common restore circuit driver transistor QP5, and the transistors QP3 and QP4 have sources connected to a common restore circuit driver transistor QP6. The transistors QP5 and QP6 have gates receiving restore circuit activating signals SP1 and SP2, respectively.

The divided bit lines BL1 and BLN and BLN and BL2 are connected to each other through transfer gate transistors QT1 and QT3, respectively, and the divided bit lines $\overline{BL1}$ and $\overline{BLN}$ and $\overline{BLN}$ and $\overline{BL2}$ are connected to each other through transfer transistors QT2 and QT4, respectively. The transfer gate transistors QT1 and QT2 have gates receiving a transfer signal T1, the transfer gate transistors QT3 and QT4 have gates receiving a transfer signal T2.

The divided bit lines BL1 and $\overline{BL1}$ are connected to bus lines BU and $\overline{BU}$ through column gate transistors QY1 and QY2. The column gate transistors QY1 and QY2 have gates receiving a column selecting signal Y.

Although a plurality of memory cells are connected to each of the divided bit lines, depending on memory capacity, only one memory cell MC1 connected to the divided bit line BL2 is typically shown herein. The memory cell MC1 comprises a capacitor CS and a transistor QS. The transistor QS has a gate being a part of a word line WL1. In addition, the capacitor CS has one electrode connected to a memory cell plate potential $V_{SG}$.

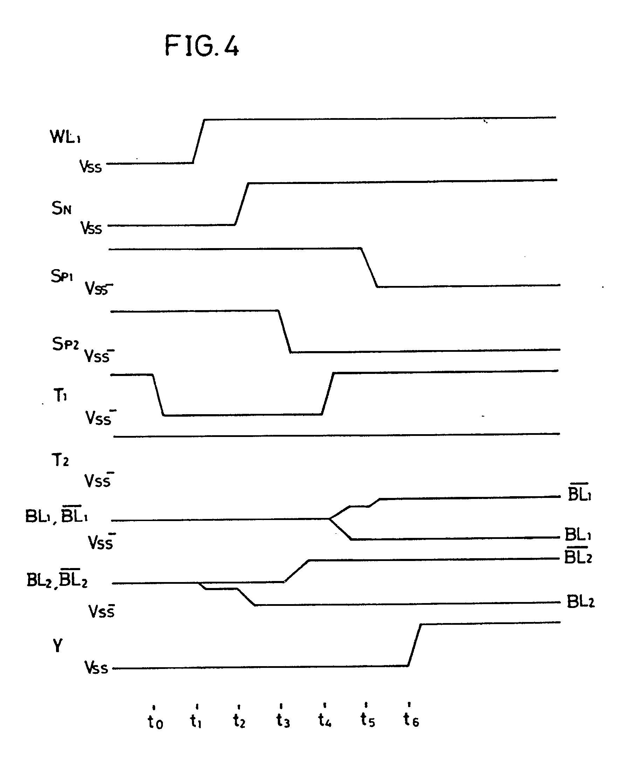

Referring now to Fig. 4 which is a waveform diagram showing operation. Operation of the circuit shown in Fig. 3, is described when the capacitor CS in the memory cell MC1 connected to the divided bit line BL2 is not charged, that is, when information "0" is stored in the memory cell MC1.

At the time $t_0$, the transfer signal T1 becomes an "L" level. Accordingly, the divided bit lines BLN and BL1 and $\overline{BLN}$ and $\overline{BL1}$ are isolated, respectively. Before the time $t_0$, the divided bit lines BL1, $\overline{BL1}$, BL2, $\overline{BL2}$, BLN and $\overline{BLN}$ are precharged at an intermediate potential $(V_{CC}-V_{SS})/2$. At the time $t_1$, the selected word line WL1 becomes an "H" level. Accordingly, the transistor QS is turned on. As a result, the potential on the divided bit line BL2 slightly lowers, so that potential difference occurs between the divided bit lines BL2 and $\overline{BL2}$. At the time $t_2$, the sense amplifier activating signal SN becomes an "H" level. As a result, potential difference is increased between the divided bit lines BL2 and $\overline{BL2}$. More specifically, the potential on the divided bit line $\overline{BL2}$ is held near the intermediate potential, while the divided bit line BL2 is discharged through the transfer gate transistor QT3 and the sense amplifier SA, so that the potential thereon becomes near a ground potential $V_{SS}$. At the time $t_3$, the restore circuit activating signal SP2 becomes an "L" level. Accordingly, the potential on the divided bit line $\overline{BL2}$ is pulled up near a power supply potential $V_{CC}$. As a result, potential difference is further increased between the divided bit lines BL2 and $\overline{BL2}$. At the time $t_4$, the transfer signal T1 becomes again an "H" level. Thus, the potentials on the divided bit lines BLN and $\overline{BLN}$ are transferred to the divided bit lines BL1 and $\overline{BL1}$, respectively. As a result, the divided bit line BL1 is discharged, so that the potential thereon becomes near the ground potential $V_{SS}$, while the potential on the divided bit line $\overline{BL1}$ is pulled up. At the time $t_5$, the restore circuit activating signal SP1 becomes an "L" level. As a result, the potential on the divided bit line $\overline{BL1}$ is pulled up near the power supply potential $V_{CC}$. At the time $t_6$, the column selecting signal Y becomes an "H" level. Thus, the potentials on the divided bit lines BL1 and $\overline{BL1}$ are transferred to the bus lines BU and $\overline{BU}$, so that information "0" stored in the memory cell MC1 is read out.

As described in the foregoing, information stored in the capacitor CS in the memory cell MC1 is first read out to the divided bit line BL2, so that potential difference between the divided bit lines BL2 and $\overline{BL2}$ is amplified by the sense amplifier SA. The divided bit line BL2 is discharged at the sense amplifier SA through the transfer gate transistor QT3. The dynamic RAM with a folded bit line structure is generally formed of low resistance materials such as aluminum or refractory metal silicide. As a result, resistance of a bit line can be reduced, so that discharge of charges on the bit line can be accelerated.

However, in the dynamic RAM with a shared sense amplifier structure as described above, a transfer gate transistor is provided between a divided bit line connected to a memory cell and a sense amplifier, so that a bit line is not formed of low resistance materials in this transistor portion. In addition, as shown in Fig. 3, since the transfer gate transistor must be provided for each pitch between bit lines, the transistor width can be made almost the same as or at most twice the pitch between bit lines. In consideration of the pitch between bit lines, the pitch between bit lines is, for example, about 3 μm in a 1 Mega-bit dynamic RAM. Therefore, the transistor width of the transfer gate transistor is limited to less than several μm. Accordingly, conductance of the transfer gate transistor is reduced, so that discharge of charges on the divided bit line is delayed when the sense amplifier operates.

Furthermore, since a source and a drain of a transfer gate transistor are formed of a diffusion layer provided in a substrate or a well, noise is transferred to a bit line through the substrate or the well, so that the sense amplifier erroneously operates.

Fig. 5 illustrates a circuit which is disclosed in the Japanese Laying-Open Gazette No. 101093/1984, as another conventional example of interest to the present invention. The circuit shown in Fig. 5 comprises only an N channel transistor, and a bit line is divided into three parts. The divided bit lines BL4 and $\overline{BL4}$ are connected to an active pull-up circuit AP and a bit line precharge circuit BC. The transfer gate transistors QT1, QT2, QT3 and QT4 are connected between the divided bit lines, and the column gate transistors QY1 and QY2 are connected between the divided bit line BL4 and the bus line BU and between the divided bit line $\overline{BL4}$ and the bus line $\overline{BU}$. A sense amplifier SA5 is connected to the divided bit lines BL5 and $\overline{BL5}$, while a sense amplifier SA6 is connected to the divided bit lines BL6 and $\overline{BL6}$. Furthermore, although a plurality of memory cells are connected to each of the divided bit lines, respectively, only a memory cell MC1 connected to the divided bit line BL5 out of memory cells connected to each of the divided bit lines is shown herein. The memory cell MC1 comprises the capacitor CS and the transistor QS. The transistor QS has a gate being a part of the word line WL1. The capacitor CS has one electrode connected to the memory cell plate potential $V_{SG}$.

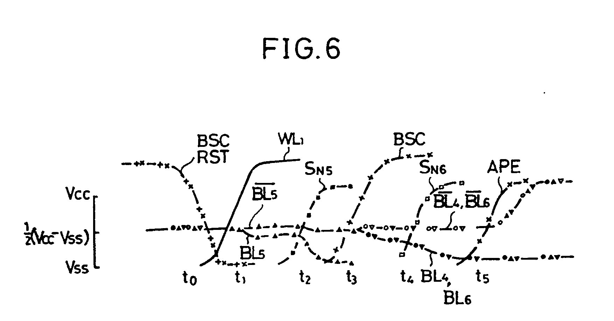

Referring now to Fig. 6 showing waveforms of operation, operation of the circuit shown in Fig. 5 is described when the capacitor CS in the memory cell MC1 is not charged, that is, when information "0" is stored in the memory cell MC1.

Before the time $t_0$, both a transfer signal BSC and a reset signal RST are at an "H" level, and all the transfer gate transistors QT1, QT2, QT3 and QT4 are turned on. Thus, the divided bit lines BL4, BL5 and BL6 are connected to each other, and the divided bit lines $\overline{BL4}$, $\overline{BL5}$ and $\overline{BL6}$ are connected to each other. In addition, since the reset signal RST becomes an "H" level, a bit line precharge circuit BC operates. As a result, each of the divided bit lines is precharged, so that the potential thereon becomes the intermediate potential $(V_{CC}-V_{SS})/2$.

At the time $t_0$, both the transfer signal BSC and the reset signal RST become an "L" level. At the time $t_1$, the potential on the selected word line WL1 becomes an "H" level. As a result, the potential on the divided bit line BL5 slightly lowers, so that potential difference occurs between the divided bit lines BL5 and $\overline{BL5}$. At the time $t_2$, a sense amplifier activating signal SN5 become an "H" level. Accordingly, the sense amplifier SA5 operates. As a result, so that potential difference is increased between the divided bit lines BL5 and $\overline{BL5}$. At the time $t_3$, the transfer signal BSC becomes an "H" level. Accordingly, the transfer gate transistors QT1, QT2, QT3 and QT4 are turned on, so that the potential on the divided bit lines BL5 and $\overline{BL5}$ are transferred to the divided bit lines BL4 and BL6 and $\overline{BL4}$ and $\overline{BL6}$, respectively. At the time $t_4$, the sense amplifier activating signal SN6 becomes an "H" level. As a result, potential difference is increased between the divided bit lines BL6 and $\overline{BL6}$ and thus, potential difference is increased between the divided bit lines BL4 and $\overline{BL4}$ and between the divided bit lines BL5 and $\overline{BL5}$. At the time $t_5$, an active pull-up signal APE becomes an "H" level. Accordingly, an active pull-up circuit APE operates. As a result, the potential on the divided bit lines $\overline{BL4}$, $\overline{BL5}$ and $\overline{BL6}$ is pulled up near the power supply potential $V_{CC}$. When the column selecting signal Y becomes an "H" level, the potentials on the divided bit lines BL4 and $\overline{BL4}$ are transferred to the bus lines BU and $\overline{BU}$, respectively, so that information is read out.

As described in the foregoing, in the circuit shown in Fig. 5, a sense amplifier is provided for each of the divided bit lines, while an active pull-up circuit is provided not for each of the divided bit lines but for an entire bit line. Therefore, since the potential on the entire bit line must be pulled up by an active pull-up circuit when the active pull-up circuit operates, an active pull-up circuit having large drive capacity is required. This increases the area occupied by the active pull-up circuit.

Additionally, in order to pull up the potential on each of the divided bit lines to the power supply potential $V_{CC}$, the gate potential of the transfer gate transistor, that is, the transfer signal BSC must be boosted over the power supply potential $V_{CC}$. However, as integration of a memory increases, a gate oxide film of the transistor tends to be thinner. For example, the gate oxide film in a 1 Mega-bit dynamic RAM is about 200 to 300Å in thickness. Therefore, if the gate potential is boosted over the power supply potential, reliability of the gate oxide film is deteriorated.

The present invention is intended as a remedy of the problems aforesaid.

The dynamic RAM of the present invention is a dynamic RAM of the type comprising : a plurality of paired bit-lines each divided into a plurality of divided bit-line pairs ; and a multiplicity of memory cells divided into blocks, each block of memory cells being connected to a respective one of the divided bit line pairs and having each side, respectively, a sense amplifier having one or more transistors of one conductivity type and a restore circuit having one or more transistors of the complementary conductivity type.

According to the present invention such a dynamic RAM is characterised in that : each respective sense amplifier and each respective restore circuit are connected to the respective divided bit-line pair ; and each respective divided bit-line pair is divided from the next by a respective single pair of switches, arranged with one switch in each bit-line.

Since in this invention each respective memory cell, sense amplifier and restore circuit are connected to a common divided bit line pair, the initial sensing and restoration operation can be performed prior to transfer operation. Delay otherwise arising due to transfer via the resistive channel of a transfer gate transistor, as in state of the art design (figure 3), is obviated and accordingly access time is improved.

Also, since both a sense amplifier and a restore circuit are provided for each memory cell/divided bit-line section, the problems of common sensing and/or restoration (e.g. figure 5) are also avoided.

In the drawings :

Fig. 1 is a circuit diagram showing a part of a structure of a dynamic RAM according to an embodiment of the present invention ;

Figs 2A and 2B are waveform diagrams showing a part of operation of the circuit shown in Fig. 1 ;

Fig. 3 is a circuit diagram showing a part of a structure of a conventional dynamic RAM ;

Fig. 4 is a waveform diagram showing a part of operation of the circuit shown in Fig. 3 ;

Figure 5 is a circuit diagram showing a part of another structure of the conventional dynamic RAM ;

and

Figure 6 is a waveform diagram showing a part of operation of the circuit shown in Figure 5.

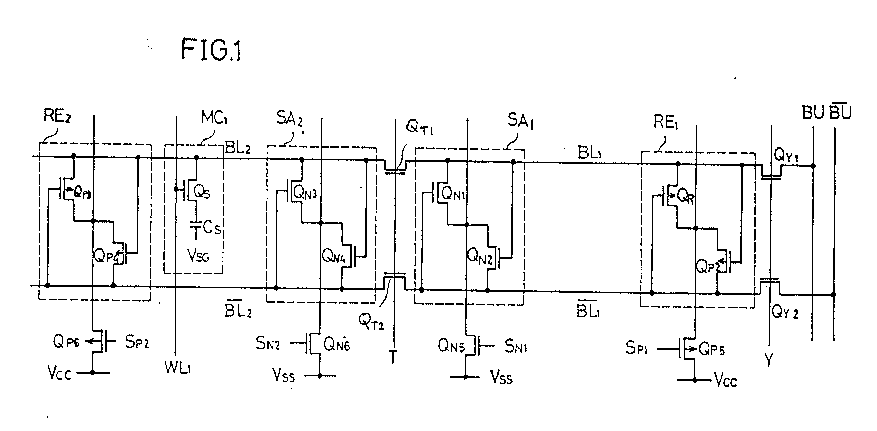

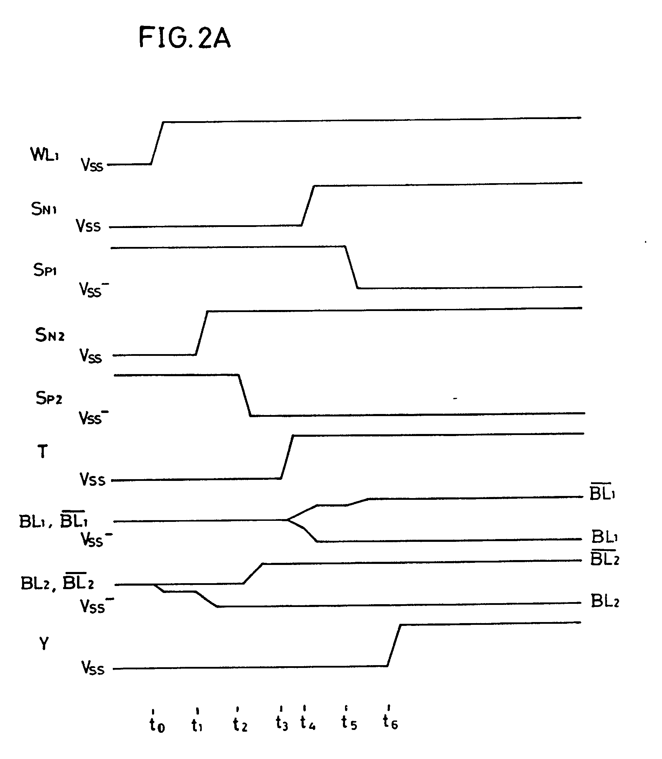

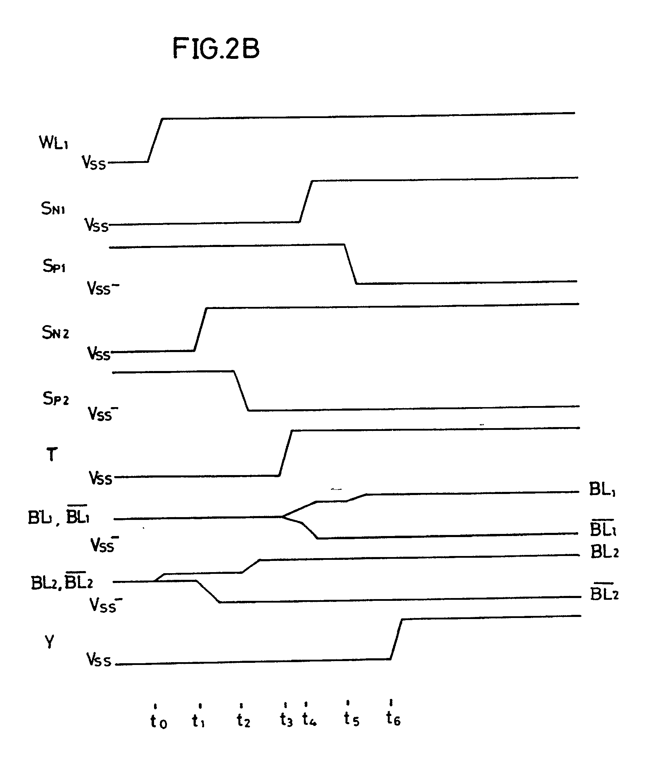

So that this invention shall be better understood, a preferred embodiment thereof will be described below and reference will be made to figures 1 and 2 of the drawings. The description that follows is given by way of example only.

Fig. 1 is a circuit diagram showing a part of a structure of a dynamic RAM according to an embodiment of the present invention. Referring to Fig. 1, a pair of bit lines with a folded bit line structure are divided into two parts, for example, BL1 and $\overline{BL1}$ and BL2 and $\overline{BL2}$. A sense amplifier SA1 and a restore circuit RE1 are connected to the divided bit lines BL1 and $\overline{BL1}$. The sense amplifier SA1 comprises N channel transistors QN1 and QN2, and the restore circuit RE1 comprises P channel transistors QP1 and QP2. A sense amplifier SA2 and a restore circuit RE2 are connected to the divided bit lines BL2 and $\overline{BL2}$. The sense amplifier SA2 comprises N channel transistors QN3 and QN4, and the restore circuit RE2 comprises P channel transistors QP3 and QP4.

The transistors QN1 and QN2 constituting the sense amplifier SA1 have sources connected to a common sense amplifier driver transistor QN5, and the transistors QN3 and QN4 constituting the sense amplifier SA2 have sources connected to a common sense amplifier driver transistor QN6. The transistors QN5 and QN6 have gates receiving sense amplifier activating signals SN1 and SN2, respectively.

The transistors QP1 and QP2 constituting the restore circuit RE1 have sources connected to a common restore circuit driver transistor QP5, and the transistors QP3 and QP4 constituting the restore circuit RE2 have sources connected to a common restore circuit driver transistor QP6. The transistors QP5 and QP6 have gates receiving restore circuit activating signals SP1 and SP2, respectively.

The divided bit lines BL1 and BL2 and $\overline{BL1}$ and $\overline{BL2}$ are connected to each other through transfer gate transistors QT1 and QT2, respectively. The transistors QT1 and QT2 have gates receiving a transfer signal T.

The divided bit line BL1 and a bus line BU and the divided bit line $\overline{BL1}$ and a bus line $\overline{BU}$ are connected to each other through column gate transistors QY1 and QY2. The transistors QY1 and QY2 have gates receiving a column selecting signal Y.

Although memory cells are connected to each of the divided bit lines, depending on memory capacity, only a memory cell MC1 connected to the divided bit line BL2 is typically shown herein. The memory cell MC1 comprises a capacitor CS and a transistor QS. The transistor QS has a gate being a part of a word line WL1. In addition, the capacitor CS has one electrode connected to a memory cell plate potential $V_{SG}$.

Operation of the circuit shown in Fig. 1 is now described. Referring to Fig. 2A which is a waveform diagram showing operation, operation is described when the capacitor CS in the memory cell MC1 is not charged, that is, when information "0" is stored in the memory cell MC1.

Before the time $t_0$, the divided bit lines BL1, $\overline{BL1}$, BL2 and $\overline{BL2}$ are precharged at an intermediate potential $(V_{CC}-V_{SS})/2$, and the transfer signal T becomes an "L" level.

At the time $t_0$, the selected word line WL1 becomes an "H" level. Accordingly, the transistor QS is turned on. As a result, the potential on the divided bit line BL2 slightly lowers, so that potential difference occurs between the divided bit lines BL2 and $\overline{BL2}$. At the time $t_1$, the sense amplifier activating signal SN2 becomes an "H" level. As a result, the potential difference is increased between the divided bit lines BL2 and $\overline{BL2}$. More specifically, the potential on the divided bit line $\overline{BL2}$ is held near the intermediate potential, while the divided bit line BL2 is discharged through the sense amplifier SA2, so that the potential thereon becomes near a ground potential $V_{SS}$. At the time $t_2$, the restore circuit activating signal SP2 becomes an "L" level. As a result, the potential on the divided bit line $\overline{BL2}$ is pulled up near a power supply potential $V_{CC}$ through the restore circuit RE2, so that potential difference is further increased between the divided bit lines BL2 and $\overline{BL2}$.

At the time $t_3$, the transfer signal T becomes an "H" level. Thus, the potentials on the divided bit lines BL2 and $\overline{BL2}$ are transferred to the divided bit lines BL1 and $\overline{BL1}$. The divided bit line BL1 begins to be discharged through the transfer gate transistor QT1 and the sense amplifier SA2, while the potential on the divided bit line $\overline{BL1}$ begins to be pulled up from the intermediate potential through the transfer gate transistor QT2 and the restore circuit RE2. At the time $t_4$, the sense amplifier activating signal SN1 becomes an "H" level. Accordingly, the sense amplifier SA1 operates. As a result, the potential on the divided bit line BL1 is discharged near the ground potential $V_{SS}$. At the time $t_5$, the restore circuit activating signal SP1 becomes an "L" level. Accordingly, the restore circuit RE1 operates. As a result, the potential on the divided bit line $\overline{BL1}$ is pulled up near the power supply potential $V_{CC}$.

At the time $t_6$, the column selecting signal Y becomes an "H" level. Accordingly, the column gate transistors QY1 and QY2 are turned on. As a result, the potentials on the divided bit lines BLI and $\overline{BL1}$ are transferred to the bus lines BU and $\overline{BU}$, respectively, so that information "0" stored in the memory cell MC1 is read out.

Referring now to Fig. 2B which is a waveform diagram showing operation, operation is described when the capacitor CS in the memory cell MC1 is not charged, that is, information "1" is stored in the memory cell MC1.

Precharge operation of the divided bit lines and operation in which the transfer signal T becomes an "L" level are performed as when information stored in the memory cell MC1 is "0".

At the time $t_0$, the potential on the selected word line WL1 becomes an "H" level. Accordingly, the transistor QS is turned on. As a result, the potential on the divided bit line BL2 slightly rises, so that potential difference occurs between the divided bit lines BL2 and $\overline{BL2}$. At the time $t_1$, the sense amplifier activating signal SN2 becomes an "H". As a result, potential difference is increased between the divided bit lines BL2 and $\overline{BL2}$. More specifically, the potential on the divided bit line BL2 is held at a little higher potential than the intermediate potential, while the divided bit line $\overline{BL2}$ is discharged through the sense amplifier SA2, so that the potential thereon becomes near the ground potential $V_{SS}$. At the time $t_2$, the restore circuit activating signal SP2 becomes an "L" level. As a result, the potential on the divided bit line BL2 is pulled up near the power supply potential $V_{CC}$ through the restore circuit RE2, so that potential difference is further increased between the divided bit lines BL2 and $\overline{BL2}$.

At the time $t_3$, the transfer signal T becomes an "H" level. Thus, the potential on the divided bit lines BL2 and $\overline{BL2}$ are transferred to the divided bit lines BL1 and $\overline{BL1}$, respectively. As a result, the potential on the divided bit line $\overline{BL1}$ begins to be discharged through the transfer gate transistor QT2 and the sense amplifier SA2, while the potential on the divided bit line BL1 begins to be pulled up through the transfer gate transistor QT1 and the restore circuit RE2. At the time $t_4$, the sense amplifier activating signal SN1 becomes an "H" level. As a result, the divided bit line $\overline{BL1}$ is discharged, so that the potential thereon becomes near the ground potential $V_{SS}$. At the time $t_5$, the restore circuit activating signal SP1 becomes an "L" level. As a result, the potential on the divided bit line BL1 is pulled up near the power supply potential $V_{CC}$.

At the time $t_6$, the column selecting signal Y becomes an "L" level. As a result, information "1" is read out into the bus lines BU and $\overline{BU}$.

In the foregoing, the structure and the operation according to the preferred embodiment of the present invention are described in detail.

In the embodiment just described the sense amplifier in each divided section is operated prior to each restore circuit in the same section. This need not be so, however, for instead they could be operated in the reverse order to achieve the same end result. It would also be possible to operate respective sense amplifiers and sense circuits simultaneously.

As described the transfer gate and column gate transistors are all of N conductivity type. Construction need not be limited to this choice since transistors of complementary conductivity type could be employed provided that suitable gating signals are selected for the construction. Similarly the memory cell transistors could be chosen as P-channel instead of N-channel, given suitable word line address potentials.

In the above described embodiment a dynamic RAM comprises a sense amplifier (SA) and a restore circuit (RE1) for each pair of divided bit lines (BL1 $\overline{BL1}$, BL2, $\overline{BL2}$). Sense operation can be performed in a fast and stable manner and the gate voltage (T) of a transfer gate transistor (QT) need not be boosted over the power supply potential, so that the access time of the dynamic RAM can be reduced, operation margin thereof is increased, and reliability is improved.

Although the present invention has been described and illustrated in detail, it is clearly understood that the same is by way of illustration and example only and is not to be taken by way of limitation, the scope of the present invention being limited only by the terms of the following claims.

## Claims

1. A dynamic random access memory comprising :

a plurality of paired bit-lines each divided into a plurality of divided bit-line pairs (BL1 and $\overline{BL1}$, BL2 and $\overline{BL2}$,...) ; and

a multiplicity of memory cells (MC1,...) divided into blocks, each block of memory cells being connected to a respective one of the divided bit line pairs (BL1 and $\overline{BL1}$, BL2 and $\overline{BL2}$,...) and having each side, respectively, a sense amplifier (SA1, SA2, ...) having one or more transistors (QN1 and QN2, QN3 and QN4...) of one conductivity type and a restore circuit (RE1, RE2,...) having one or more transistors (QP1 and QP2, QP3 and QP4,...) of the complementary conductivity type ;

which memory is characterised in that :

each respective sense amplifier (SA1, SA2,...) and each respective restore circuit (RE1, RE2,...) are connected to the respective divided bit-line pair (BL1 and $\overline{BL1}$, BL2 and $\overline{BL2}$,...) ; and

each respective divided bit-line pair (BL1 and $\overline{BL1}$, ...) is divided from the next (BL2 and $\overline{BL2}$,...) by a respective single pair of switches (QT1 and QT2 ; ...), arranged with one switch (QT1, QT2 ;...) in each bit-line.

2. A memory as claimed in claim 1 when operated such that :

a memory cell (MC1) is selected by word line address (WL1) ;

the sense amplifier (SA2) and restore circuit (RE2)each side of the selected memory cell (MC1) are operated ; then

the pair of switches (QT1 and QT2) between the divided bit-line pair (BL2 and $\overline{BL2}$), connected to the selected memory cell, and the next divided bit-line pair (BL1 and $\overline{BL1}$) are closed and

the sense amplifier (SA1) and restore circuit (RE1) connected to this next divided bit-line pair (BL1 and $\overline{BL1}$) are operated.

## Patentansprüche

1. Dynamischer Random-Access-Speicher, enthaltend :

eine Vielzahl von paarweisen Bitleitungen, wovon jede in eine Vielzahl von geteilten Bitleitungspaaren (BL1 und $\overline{BL1}$, BL2 und $\overline{BL2}$...) unterteilt ist ; und

mehrere Speicherzellen (MC1,...), die in Blöcke aufgeteilt sind, wobei jeder Speicherzellenblock mit einer der geteilten Bitleitungspaare (BL1 und $\overline{BL1}$, BL2 und $\overline{BL2}$,...) verbunden ist und an jeder Seite einen Leseverstärker (SA1, SA2,...), mit einem oder mehreren Transistoren (QN1, QN2, QN3 und QN4,...) eines Leitfähigkeitstyps bzw. eine Wiederherstellschaltung (RE1, RE2,...) mit einem oder mehreren Transistoren des komplementären Leitfähigkeitstyps hat, dadurch gekennzeichnet, daß

jeder Leseverstärker (SA1, SA2,...) und jede Wiederherstellschaltung (RE1, RE2,...) mit dem geteilten Bitleitungspaar verbunden ist (BL1 und $\overline{BL1}$, BL2 und $\overline{BL2}$,...) ; und

jedes geteilte Bitleitungspaar (BL1 und $\overline{BL1}$,...) von dem nächsten Paar (BL2 und $\overline{BL2}$...) durch ein einziges Schalterpaar (QT1 und QT2 ;...) getrennt ist, wobei sich in jeder Bitleitung ein Schalter befindet.

2. Speicher nach Anspruch 1, bei dem dann eine Speicherzelle (MC1) von einer Wortleitungsadresse ausgewählt (WL1) ist und der Leseverstärker (SA2) sowie die Wiederherstellschaltung (RE2) an jeder Seite der ausgewählten Speicherzelle arbeiten, das Schalterpaar (QT1 und QT2) zwischen dem geteilten Bitleitungspaar (BL2 und $\overline{BL2}$), das mit der ausgewählten Speicherzelle verbunden ist, und dem nächsten geteilten Bitleitungspaar (BL1 und $\overline{BL1}$) geschlossen ist, und der Leseverstärker (SA1) sowie die Wiederherstellschaltung (RE1), die mit dem nächsten geteilten Bitleitungspaar (BL1 und $\overline{BL1}$) verbunden ist, arbeiten.

## Revendications

1. Mémoire aléatoire dynamique comprenant :

un ensemble de lignes de bit appariées partagées chacune en une pluralité de paires de lignes de bit partagées (BL1 et $\overline{BL1}$, BL2 et $\overline{BL2}$,...) ; et

un ensemble de cellules de mémoire (MC1,...) partagées en blocs, chaque bloc de cellule de mémoire étant relié à l'une respective des paires de lignes de bit partagées (BL1 et $\overline{BL1}$, BL2 et $\overline{BL2}$...) et comportant de chaque côté, respectivement, un amplificateur de détection (SA1, SA2,...) avec un ou plusieurs transistors (QN1 et QN2), QN3 et QN4,...) d'un premier type de conductivité et un circuit de rafraîchissement (RE1, RE2,...) ayant un ou plusieurs transistors (QP1 et QP2, QP3 et QP4,...) du type à conductivité complémentaire ;

laquelle mémoire est carctérisée en ce que :

chaque amplificateur détecteur respectif (SA1, SA2,...) et chaque circuit de rafraîchissement respectif (RE1, RE2,...) sont connectés aux paires de lignes de bit partagées respectives (BL1 et $\overline{BL1}$, BL2 et $\overline{BL2}$,...) et

chaque paire de lignes de bit partagées respective (BL1 et $\overline{BL1}$,...) est séparée de la suivante (BL2 et $\overline{BL2}$,..) par une unique paire correspondante de commutateurs (QT1 et QT2,...) agencés avec un seul commutateur (QT1, QT2,...) dans chaque ligne de bit.

2. Mémoire selon la revendication 1 lorsqu'elle fonctionne de telle manière que :

une cellule de mémoire (MC1) est sélectionnée par une adresse de ligne de mot (WL1) ;

l'amplificateur de détection (SA2) et le circuit de rafraîchissement (RE2) montés de chaque côté de la cellule de mémoire sélectionnée (MC1) sont mis en fonctionnement ; puis

la paire de commutateurs (QT1 et QT2) montée entre la paire de lignes de bit partagées (BL2 et $\overline{BL2}$), connectée à la cellule de mémoire sélectionnée, et la paire suivante de lignes de bit partagées (BL1 et $\overline{BL1}$) sont rapprochées et que

l'amplificateur de détection (SA1) et le circuit de rafraîchissement (RE1) connectés à cette paire suivante de lignes de bit partagées (BL1 et $\overline{BL1}$) sont mis en fonctionnement.

FIG.1

## FIG.2A

## FIG.2B

FIG.3

# FIG.4

FIG.5

# FIG.6